# EUROPEAN PATENT APPLICATION

(11) **EP 2 712 076 A1**
(43) Date of publication of application: **26.03.2014**
(21) Application number: 12290304.0
(22) Date of filing: 19.09.2012
(51) Int. Cl.: H03F 1/02, H03F 3/24, H03F 3/72

(54) **Power amplifier for mobile telecommunications**

(71) Applicant: Alcatel Lucent, 75007 Paris (FR)
(72) Inventor: Wong, James N., Richmond, Surrey TW9 3JX (GB); Woodington, Simon P., Liandaff, Cardiff CF5 2JL (GB)
(74) Representative: Lupton, Frederick

(57) **Abstract**

A Doherty amplifier including a main amplifier (6), and a peak amplifier (8), wherein the peak amplifier and the main amplifier are driven by respective driver amplifiers (10, 12), wherein the onset of conduction of the peak amplifier is monitored, by inserting a test pulse into the input RF signal during a null period of the input traffic signal, and monitoring (18) the form of the test pulse at the output of the Doherty amplifier, whereby to set a threshold value of the traffic RF input signal for switching on the peak driver amplifier (12, 20).

## Description

### Field of the Invention

The present invention relates to a power amplifier employed in mobile telecommunications systems, particularly an RF power amplifier commonly known as a Doherty amplifier.

### Background Art

US Patent No. 2,210,028 to Doherty describes the principle of operation of the Doherty amplifier. A Doherty amplifier includes a main or carrier amplifier, usually biased into class B or AB, with a peaking amplifier coupled in parallel and biased into class C, so as to switch on at modulation peaks. This provides a more efficient use of amplifier capability, since the carrier amplifier may be set to provide maximum power efficiency at saturation, backed off by -6 dB from the peak output. When the peaking amplifier switches in at the -6 dB point to increase power to the antenna load, an impedance inverter at the output of the carrier amplifier senses an increase in load impedance and provides an apparent lower impedance at the carrier amplifier output, thereby increasing power output of the carrier amplifier. Impedance inverters are usually implemented by quarter wavelength (λ/4) transmission line lengths.

There has been a great deal of development in improving the operation and efficiency of the Doherty Amplifier, particularly in the field of mobile telecommunications, where such amplifiers may be implemented in "pallets", which are unitary circuit packs containing a complete amplification stage. "Efficiency" is generally regarded as the ratio of RF transmission output power to DC input power. In delivering more efficient power amplifier pallets, the power consumption of the driver stage is often overlooked. The average efficiency of driver stages is between 10-15% for an average RF output power of 1-2W. This corresponds to a DC consumption of 10-20W for a single transmit stage. As developments in the final stage Doherty Amplifier begin to reach limits for higher efficiency, it becomes critical to consider the elements of the entire amplification chain.

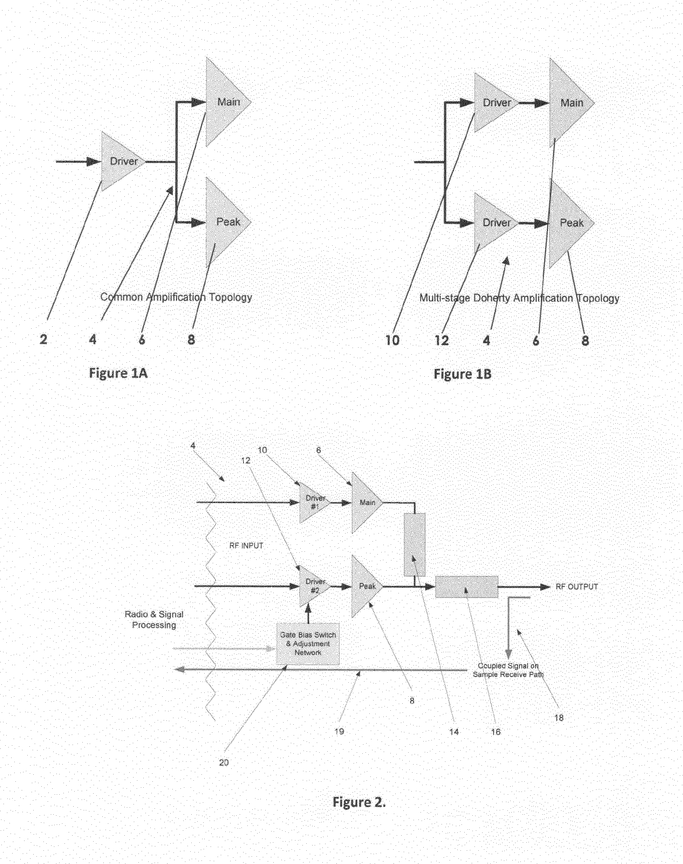

As an example, as shown schematically in Figure 1, a known single transmit stage amplifier pallet comprises a driver amplifier 2, which amplifies and conditions the input signal to a Doherty amplifier 4, comprising Main and Peak amplifiers 6, 8. The pallet delivers 50W RF power with 40% pallet efficiency requiring a total DC consumption of 125W. A 10W reduction in driver DC consumption will improve this pallet efficiency by 3.5% to 43.5% and a 20W reduction in driver DC consumption will result in a pallet efficiency of 47.6%, without having to consider the performance of the final stage Doherty amplifier. In view of these considerations, smaller sized drivers have been employed to provide improvement in pallet efficiencies. Such drivers operate in Class AB mode for a balance between linearity and efficiency.

Multi-Stage Doherty architectures have also been employed, as shown schematically in Figure 2, wherein a pallet includes separate drivers 10, 12 for respective Main and Peak amplifiers 6, 8. The driver amplifiers 10, 12 are biased in Class AB mode. Although this approach brings some level of efficiency benefits, there is unfortunately a negative impact on the line-up gain on the peak path, since the gain of the driver stage is dependent on the average level of the input RF signal. To overcome this, either an additional gain stage or an asymmetric input signal split, or both, is required. This negates the efficiency benefits when an additional stage is required.

### Summary of the Invention

Embodiments of the invention provide a Doherty amplifier configuration, wherein respective driver amplifiers are provided for each of the main and peak amplifiers. A mechanism is provided for monitoring the conduction state of the peak amplifier, and for adjusting the conduction state of its driver amplifier, so that the driver amplifier and peak amplifier switch on and off at the same time, or approximately so, so that the driver amplifier is only switched on close to the condition in which the peak amplifier switches on in Class C, during a fluctuating input signal.

Conveniently a monitoring operation takes place during null periods of an input signal, which occur at defined intervals for the various types of modulation formats for mobile telecoms signals. In this monitoring operation, the instants at which the peak amplifier, in its Class C operation conducts, are detected and recorded. This information is then employed during active traffic periods of an input signal, to set a threshold value of the RF input signal to switch on the driver amplifier, only during conduction periods of the peak amplifier.

Various mechanisms may be envisaged for this monitoring operation, including applying fixed values of input signal over several null periods, in order to determine conductive and non-conductive states of the peak amplifier. As preferred however, a pulsed input test signal is applied during null periods, and the peaking amplifier is monitored in real-time in order to detect its conduction state. Whilst a series of pulses might be applied during a single null period of various heights in order to determine conduction states, as preferred, a single test input pulse may be applied with sloping leading and trailing edges, and the point along each edge at which the peak amplifier switches on/ off is recorded. To facilitate this, the sloping edges are each formed as a staircase of incremental steps of voltage amplitude. In a further preferred arrangement, separate test pulses are applied to the main amplifying path and the peak amplifying path, simultaneously. One pulse has a staircase form on the leading edge, and the other has a stair case form on the lower trailing edge. Analysis of the received pulse signal after amplification by the Doherty amplifier permits identification of the point at which the peaking amplifier switches between on and off states, and also the point at which the main amplifier makes a transition between linear and compression regions, as will be explained in more detail hereinafter. This enables a threshold value to be set for switching on of the peak driver amplifier in active traffic periods of the RF input signal, so that the peak driver amplifier is switched on at approximately the same time, preferably shortly before, the peak amplifier conducts in response to a peak in the input signal. As preferred, a switch mechanism is provided for switching the gate bias voltage of the peak driver amplifier, in order to turn on/off the driver amplifier.

In a first aspect, the present invention provides a power amplifier including a main amplifier, and at least one peak amplifier, the output of said main amplifier being coupled to a power amplifier output, the output of said one peak amplifier being coupled to said power amplifier output, and an impedance inversion means coupled to said power amplifier output, and wherein said one peak amplifier is configured to switch on with increase in input power, and including a peak driver amplifier coupled to drive a said peak amplifier, and driver control means for detecting the conduction state of said peak amplifier, and for controlling the conduction state of said peak driver amplifier in relation thereto.

In a second aspect, the invention provides a method of controlling a power amplifier, the power amplifier including a main amplifier, and at least one peak amplifier, the output of said main amplifier being coupled to a power amplifier output, the output of said one peak amplifier being coupled to said power amplifier output, and an impedance inversion means coupled to said power amplifier output, and wherein said one peak amplifier is configured to switch on with increase in input power, and including a peak driver amplifier coupled to drive a said peak amplifier,
the method comprising detecting the conduction state of said peak amplifier, and controlling the conduction state of said peak driver amplifier in relation thereto.

The present invention is applicable to all types of Doherty amplifier, including N-way Doherty amplifiers having 2, 3 or more peak amplifiers operating in a cascade arrangement, and inverted Doherty amplifiers wherein the positions of the peak amplifier and the main amplifier are reversed within the Doherty configuration.

### Brief Description of the Drawings

A preferred embodiment of the invention will now be described, by way of example only, with reference to the accompanying drawings, wherein:
Figure 1A is a schematic view of a known configuration of a Doherty amplifier with a driver amplifier;
Figure 1B is a schematic view of a known configuration of a multi stage Doherty amplifier with respective driver amplifiers;
Figure 2 is a schematic representation of an embodiment of the present invention;
Figure 3 is a schematic view of a control circuit of this embodiment;
Figure 4 is a circuit diagram of a means for switching the gate voltage of the peak driver amplifier, in accordance with the embodiment;
Figure 5 comprises views of a test pulse signal inserted in null periods of an input RF signal, in accordance with the embodiment;
Figure 6 comprises views of the of the monitored form of the test pulse signal appearing at the output of the Doherty amplifier, showing threshold regions of conduction of a peak amplifier and transition of the main amplifier between compression and linear regions;
Figure 7 is an illustration of an input RF traffic signal, showing peak values of the signal above a monitored threshold value for conduction of the peak driver amplifier;
Figure 8 is an illustration of ON/OFF toggle signals generated for the peak driver amplifier for the waveform of Figure 7;
Figure 9 is an illustration of ON/OFF toggle with time delay compensation; and
Figure 10 is a frequency spectral plot of a typical 5MHz WCDMA signal.

### Description of an Embodiment of the Invention

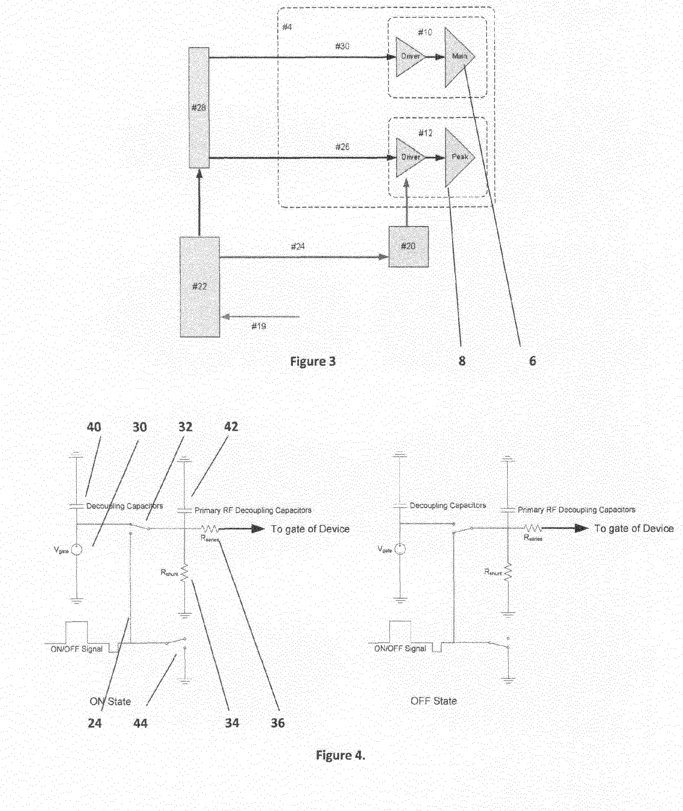

Referring to Figures 2 and 3, an embodiment comprises a Doherty amplifier 4 having a main amplifier 6, a peak amplifier 8, with a quarter wavelength transmission line 14 forming an impedance inverter, coupled from the output of the main amplifier to the output of the peak amplifier. The output of the peak amplifier is coupled through a further quarter wavelength transmission line 16 to the output of the Doherty amplifier, RF OUTPUT. A main driver amplifier 10, Driver #1, drives the main amplifier, and a peak driver amplifier 12, Driver #2, drives the peak amplifier. Driver 10 is biased in Class AB for balance between efficiency and linearity. Driver 10 is sized accordingly to the output RF power requirements. Driver 12 drives the peak amplifier 8 and is biased for Class AB operation. Driver 12 is identically sized to Driver 10, in this embodiment, but may be of different size. Main and peak amplifiers 6, 8 may be symmetrically or asymmetrically driven, with different input power ratios.

The RF OUTPUT of the amplifier 4 is sensed by an RF coupler 18, and the detect signal is applied on line 19 to a monitor and control circuit as shown in Figure 3. The monitor circuit includes a processor 22, which may comprise or incorporate a DSP, having an output 24 coupled to control a Gate Bias Switch and Adjustment circuit 20, which controls the gate voltage to driver 12, so as to selectively switch driver 12 on or off (driver 12 comprising a single FET transistor).

Circuit 20 is shown in more detail in Figure 4, and acts as a switch for turning 'ON/OFF' the gate supply bias to Driver 12 during conducting/nonconducting regions of the peak amplifier. The circuit is shown on the left hand side in an ON state, and on the right hand side in an OFF state. The circuit comprises a source 30 of gate voltage (gate voltage can be supplied through existing discrete signal monitoring and control ICs such as Analog Devices AD7294 or Texas Instruments AMC7812) coupled through a switch 32 to the gate of the driver amplifier transistor (not shown), via a voltage divider network Rₛₕᵤₙₜ 34 and Rₛₑᵣᵢₑₛ 36. Decoupling capacitors 40, 42 are provided. Switch 32 may be a transistor switch in common base configuration, with the gate controlled by control output 24 from processor 22.

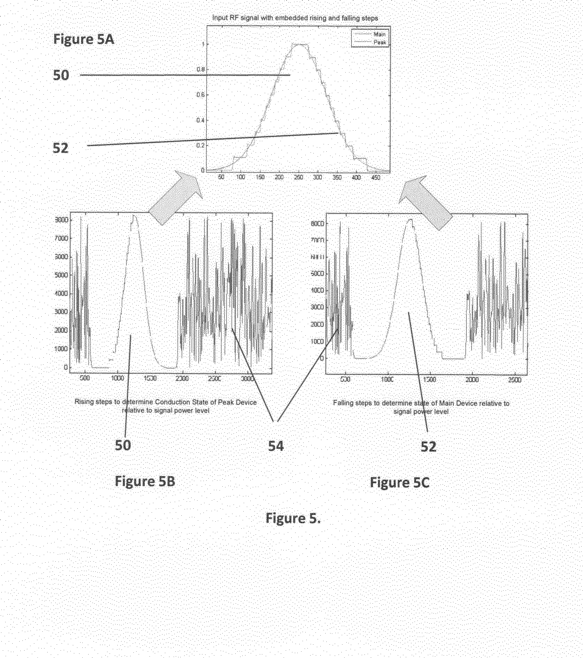

Processor 22 is programmed to develop test pulse signals, which are fed to a signal source 28, source 28 applying RF input signals to the Doherty amplifier on input lines 26, 30. The test pulse signals are of the form shown in Figures 5A, 5B and 5C. Figure 5A shows two test pulses 50, 52, pulse 50 having a leading edge or flank which is formed as a stair case of rising step increments and a trailing edge which has a smooth form without steps. Pulse 52 has a trailing edge which is formed as a stair case of rising step increments and a leading edge which has a smooth form without steps. Figures 5B and 5C show respectively pulses 50, 52 inserted into the null period of a typical RF 10MHz LTE signal 54. The test pulses have an amplitude corresponding to the highest peaks of the modulated signal, and the pulses can be embedded into any signals of the different modulation formats of mobile telecoms (WCDMA, LTE, GSM) during their null periods.

Signal source 28 provides test pulse 50 on line 26 to apply the pulse to the input of peak driver amplifier 12, during a null period of the RF INPUT signal. The rising steps of pulse 50 will determine the conduction state of the peak device relative to the power level (amplitude) of the modulated signal peaks, as will be explained.

Signal source 28 provides test pulse 52 on line 30 to apply the pulse to the input of main driver amplifier 10, during a null period of the RF INPUT signal. The falling steps of pulse 52 allow the compression state of the main device to be determined relative to the amplitude of the modulated signal peaks, as will be explained.

In normal operation, a traffic signal input RF INPUT will be fed to the Doherty amplifier. Driver 10 and main amplifier 6 remain on, and the amplified input provides the RF OUTPUT. During peaks of the input signal, driver 12 and peak amplifier 8 are switched on, and provide further contribution to the RF OUTPUT. Peak amplifier 8 is biased in Class-C mode, the precise bias conditions having been set up as an initial operation. Driver 12 is controlled by switch network 20 to switch on when peak amplifier 8 is conducting, but otherwise to remain off, as described below.

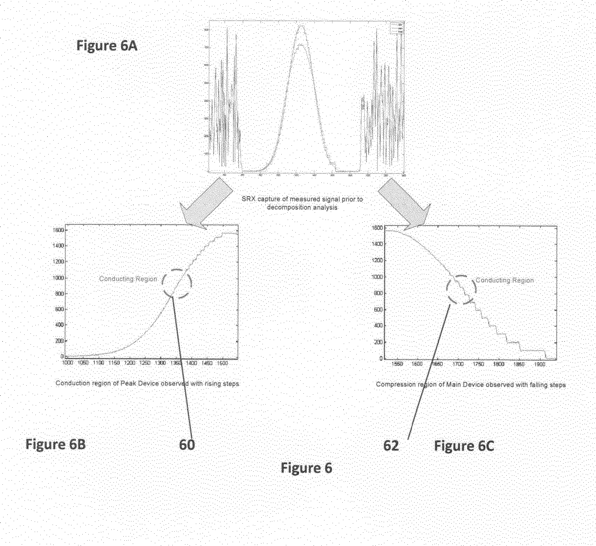

In a null period of the traffic signal, pulses 50, 52 are simultaneously applied to the Doherty amplifier, and Figures 6A, 6B and 6C show the signal as received at 18, 19, resulting from two superimposed pulses as in Figure 6A. The received signal is decomposed into leading and trailing edges as shown in Figure 6B and 6C, by processor 22, in order to determine regions identifying the conduction and compression states of the peak and main devices. Thus in Figure 6B, it will be noted that the lower part of the leading edge of the received signal is smooth. This corresponds to non-conduction of peak amplifier 8, but amplification by main amplifier 6 of the smooth leading edge of pulse 52. In the upper part of the leading edge, a stair case of rising step increments appear, corresponding to the condition of peak amplifier switched on and amplifying the leading edge of pulse 50. A conduction region shown by circle 60 indicates the height of the received signal pulse when peak amplifier is in a transitional state from off to on conditions.

In Figure 6C, it will be noted that the upper part of the trailing edge of the received signal is smooth. This corresponds to amplification by peak amplifier 8 of the smooth trailing edge of pulse 50. Since main amplifier 6 is in the saturation or compression region, the steps in the upper part of trailing edge of pulse 52 will not be amplified. In the lower part of the leading edge, a stair case of rising step increments appear, corresponding to the condition of main amplifier 6 entering its linear region and amplifying the trailing edge of pulse 52. A conduction region shown by circle 62 indicates the height of the received signal pulse when main amplifier 6 is in a transitional state between linear and compression conditions.

Processor 22 operates to process these leading and trailing edges, for example by comparison with pulses 50, 52 as generated by the processor, in order to determine the precise location of conduction regions 60, 62. Region 60 is of principal interest, since this indicates the point at which peak amplifier 8 switches on. This region is recorded by processor 22, in order to set a threshold voltage level of the monitored RF input signal to subsequently send on line 24 a signal to peak driver amplifier 12 to switch it on at the same time, or just before peak amplifier 8 switches on, in amplification of traffic signals.

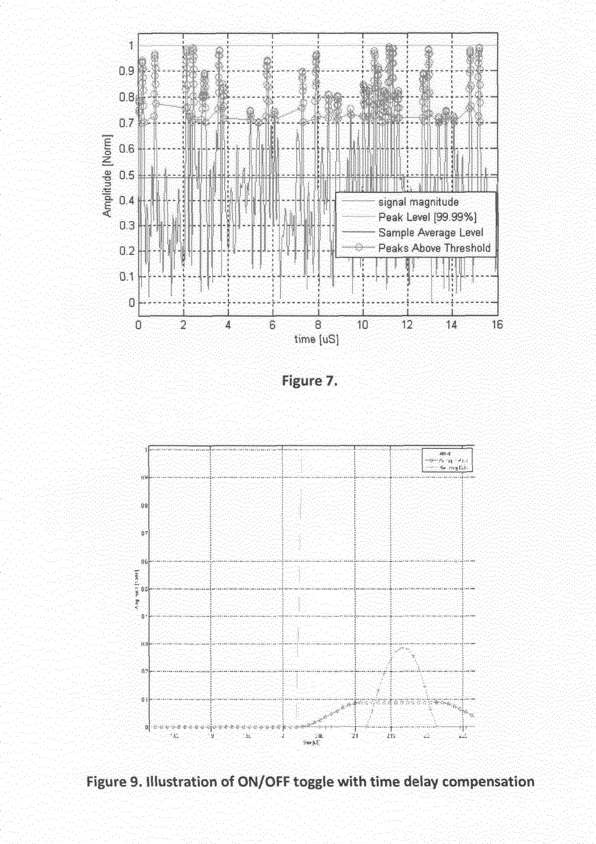

This is indicated in Figure 7, which shows signal amplitude thresholds of a traffic signal, in terms of an average level (0.5) at which a signal is sent on line 24 to turn on drive amplifier 12, a threshold level for peak amplifier conduction (0.7), and peaks above the threshold.

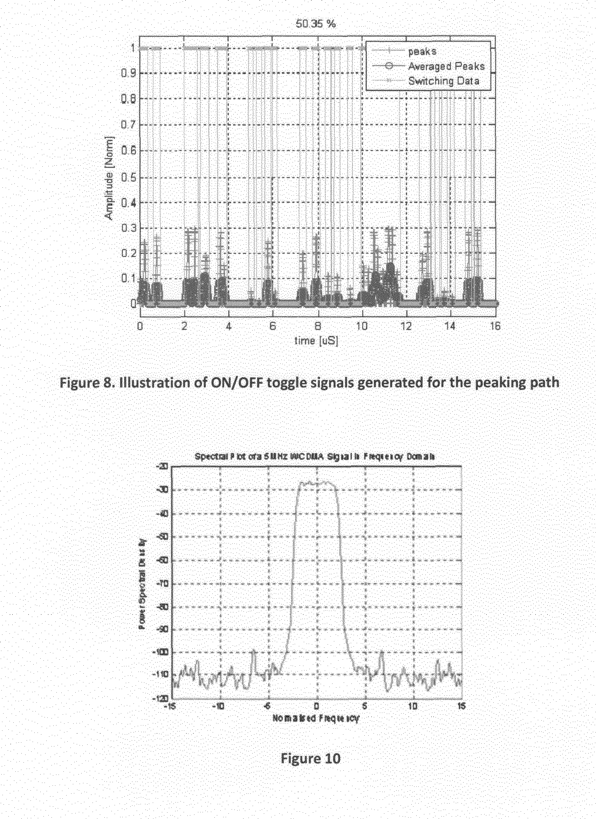

Figure 8 shows ON/OFF toggle signals generated for the peaking path for the waveform of Figure 7. The solid lines at the base of the Figure, between peaks, indicate those times when driver amplifier 12 is Off, and the solid lines at the top of the Figure indicate those times when the driver amplifier is On, embracing the peaks of the signal. Thus the conducting regions 60 of Figure 6 have been translated into the ON/OFF switching data to the Gate Bias Switch & Adjustment network 24 of the peak path driver. The ON/OFF duty cycle, shown as 50%, changes depending on the threshold level set, and as shown in Figures 7 and 8, is set so that the driver amplifier switches on shortly before the peak amplifier conducts, and switches off shortly after the peak amplifier is non-conductive.

Figure 9 shows an example of the ON/OFF toggle state with time compensation to allow for rise/fall time of switches. The fall-time during the off-state is accelerated as shown in Figure 4 by means of a 2^{nd} switch 44 that discharges the de-coupling capacitors 40, 42 on the gate bias network. In figure 9, the vertical line represents the ON/OFF signal on line 24, the narrow peaked curve represents the peak of the RF input signal when the peak amplifier is conducting, and the broad humped curve represents the gate voltage during the switching on of the circuit as shown in Figure 4, with operation of switch 44 discharging capacitors 38, 40, to deliver gate voltage to the peak driver amplifier. It will be noted gate voltage is applied shortly before and shortly after the appearance of the amplified signal peak.

Figure 10 shows a spectral plot in frequency domain of a typical 5MHz WCDMA signal. When this spectrum is viewed in time domain, the varying amplitude with respect to time appears as for example in Figures 7 and 8.

As regards conduction region 62, indicating the condition of main amplifier 6, this information provided by processor 22 will be used to check that the Doherty amplifier is setup properly by correlating it with the conduction region 60. If these two regions are significantly out of alignment in terms of pulse height, adjustment of amplifiers 6, 8 may be necessary.

Advantages of the present invention are as follows:
Improvement of DC power consumption of RF power amplifier pallets;

Allowing the peak path driver of an RF power amplifier [employing a Doherty architecture on the final stage] pallet to operate during the conducting states of the signal and peak devices. Further improvements in efficiency could be obtained this way.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A power amplifier including a main amplifier, and at least one peak amplifier, the output of said main amplifier being coupled to a power amplifier output, the output of said one peak amplifier being coupled to said power amplifier output, and an impedance inversion means coupled to said power amplifier output, and wherein said one peak amplifier is configured to switch on with increase in input power,
and including a peak driver amplifier coupled to drive a said peak amplifier, and driver control means for detecting the conduction state of said peak amplifier, and for controlling the conduction state of said peak driver amplifier in relation thereto.

2. A power amplifier according to claim 1, wherein said control means is arranged to switch on said peak driver amplifier at approximately the same time as, preferably shortly before, said peak amplifier conducts in Class-C mode.

3. A power amplifier according to claim 1 or 2, wherein said control means is arranged to provide at least one test pulse to input signal source means of said power amplifier during quiescent periods of the power amplifier input signal, and said control means is arranged to monitor the form of said one test pulse at said power amplifier output in order to detect and to record the onset of conduction of said peak amplifier, in order to control conduction of said peak driver amplifier during input traffic signals.

4. A power amplifier according to claim 3, wherein said control means and said source means are arranged so that a said test pulse is transmitted through said peak amplifier, but not said main amplifier, or alternatively or in addition through said main amplifier but not said peak amplifier.

5. A power amplifier according to claim 3 or 4, wherein a said test pulse has leading and trailing edges, and one or more of said edges is formed as a staircase of incremental steps.

6. A power amplifier according to claim 4 and 5, wherein a said test pulse is transmitted through said peak amplifier, but not said main amplifier, and said control means is arranged to detect the appearance of said incremental steps in said form of said one test pulse.

7. A power amplifier according to claim 6, wherein a further said test pulse is transmitted through said main amplifier, but not said peak amplifier, and said control means is arranged to detect the appearance of said incremental steps in the falling edge of said form of said one test pulse, in order to monitor the transition of said main amplifier from its compression state.

8. A power amplifier according to any preceding claim, wherein said control means includes switch means for switching on a gate voltage bias for said peak driver amplifier, and said control means is arranged to set a threshold value of an RF input signal for operating said switch means in dependence on the detected conduction state of said peak amplifier.

9. A power amplifier according to claim 8, wherein said switch means includes decoupling capacitance means, and including further switching means for grounding said decoupling capacitance means when said switch means switches on said gate voltage bias.

10. A method of controlling a power amplifier, the power amplifier including a main amplifier, and at least one peak amplifier, the output of said main amplifier being coupled to a power amplifier output, the output of said one peak amplifier being coupled to said power amplifier output, and an impedance inversion means coupled to said power amplifier output, and wherein said one peak amplifier is configured to switch on with increase in input power, and including a peak driver amplifier coupled to drive a said peak amplifier,
the method comprising detecting the conduction state of said peak amplifier, and controlling the conduction state of said peak driver amplifier in relation thereto.

11. A method according to claim 10, comprising switching on said peak driver amplifier at approximately the same time as, preferably shortly before, said peak amplifier conducts in Class-C mode.

12. A method according to claim 11, including setting a threshold value of input RF signal in dependence on said detecting step, and switching on said peak drive amplifier when the RF input signal reaches said threshold value.

13. A method according to claim 10, 11 or 12, comprising providing at least one test pulse to the input of said power amplifier during quiescent periods of the power amplifier input signal, and monitoring the form of said one test pulse at said power amplifier output in order to detect and to record the onset of conduction of said peak amplifier, in order to control conduction of said peak driver amplifier during input traffic signals.

14. A method according to claim 13, wherein a said test pulse is transmitted through said peak amplifier, but not said main amplifier, and detecting the change in appearance an edge of the test pulse on the onset of conduction of said peak amplifier.

15. A method according to claim 14, wherein said test pulse has said edge formed as a staircase of incremental steps, and the method comprising detecting the appearance of said incremental steps in said form of said test pulse.
